# EUROPEAN PATENT APPLICATION

(11) **EP 4 651 640 A1**
(43) Date of publication of application: **19.11.2025**
(21) Application number: 23916153.2
(22) Date of filing: 20.11.2023
(51) Int. Cl.: H05K 3/00, H01L 23/12, H01L 23/36, H05K 1/02, H05K 3/20

(54) **CONVEYANCE JIG, CIRCUIT BOARD MANUFACTURING DEVICE, AND CIRCUIT BOARD MANUFACTURING METHOD**

(30) Priority: 10.01.2023 JP 2023001921
(71) Applicant: NHK Spring Co., Ltd., Kanagawa 236-0004 (JP)
(72) Inventor: YANO, Shinya, Yokohama-shi, Kanagawa 236-0004 (JP)
(74) Representative: DREISS Patentanwälte PartG mbB
(86) International application number: PCT/JP2023/041667
(87) International publication number: WO 2024/150536

(57) **Abstract**

A common conveyance jig that is a conveyance jig employed to manufacture a circuit board including a board formed from a metal material, an insulation layer fixed on the board, and a circuit part formed from an electroconductive material and fixed on the insulation layer. The common conveyance jig includes a base part that supports the board from below, and a plurality of movement-restricting units that detachably engage with the base part and restrict displacement, in a horizontal direction, of the board supported from below by the base part.

## Description

### Technical Field

The present disclosure relates to a conveyance jig, a circuit board manufacturing device and a circuit board manufacturing method.

### Background Art

A device disclosed in Japanese Patent Application Laid-Open (JP-A) No. 2003-48249 sticks a printed circuit board sheet having a surface formed with an irregular shaped profile and a cover sheet thereof or the like together by successively pressure bonding two or more sheets, at least one of the sheets being formed with irregularities, under a high vacuum. When sticking two sheets together using the device described in this document, firstly, the two sheets are disposed between upper and lower press-contact members and clamped between the upper and lower press-contact members. When this is performed, locations where these two sheets are compressed by the upper and lower press-contact members are sealed completely. Together with the two sheets being compression-fixed by the upper and lower press-contact members, an airtight compartment is formed when a lower face of a sliding frame body is closely adhered to an upper face of a cradle at high airtightness across the entire surface, with the airtight compartment being surrounded by an inner peripheral face of a frame body on the cradle and the lower face of a pressing block. This means that gas bubbles present between the two sheets can be removed by creating a vacuum inside this compartment. Furthermore, the two sheets are configured so as to be thermocompression bonded under a high vacuum by being compressed between the cradle and the pressing block while also being thermopressed.

### SUMMARY OF INVENTION

### Technical Problem

However, in processes to manufacture a circuit board, a conveyance jig is conceivably employed to convey a member for configuring the circuit board. In such cases, preferably a common conveyance jig capable of accommodating plural specifications of circuit board is employed, however the device described in JP-A No. 2003-48249 does not consider such demands.

In consideration of the above circumstances, an object of the present disclosure is to provide a conveyance jig, a circuit board manufacturing device, and a circuit board manufacturing method that are capable of accommodating plural specifications of circuit board.

### Solution to Problem

A conveyance jig of a first aspect is a conveyance jig employed to manufacture a circuit board including a board that is formed from a metal material, an insulation layer that is formed in a sheet shape from an insulating material and that is fixed on the board, and a circuit part that is formed from an electroconductive material and that is fixed on the insulation layer. The conveyance jig includes a base part that supports the board from below, and a plurality of movement-restricting units that detachably engage with the base part and restrict displacement, in a horizontal direction, of the board supported from below by the base part.

In the conveyance jig of the first aspect, the board is supported from below by the base part. Moreover, horizontal direction displacement of the board is restricted by the plural movement-restricting units in a state in which the board is supported from below by the base part. The conveyance jig of the first aspect is configured such that the plural movement-restricting units detachably engage with the base part. This thereby enables boards having different shapes and dimensions to each other to be supported on the base part by varying the engagement locations of the plural movement-restricting units with the base part. The conveyance jig of the first aspect is thereby able to accommodate plural specifications of circuit board.

A conveyance jig of a second aspect is the conveyance jig of the first aspect, further including a gripped unit that is fixed to a different portion of the base part from a portion at which the board is supported from below and from portions with which the plurality of movement-restricting units engage, and that is gripped by a gripping member.

In the conveyance jig of the second aspect, the gripped unit gripped by the gripping member is fixed to such a location on the base part. The conveyance jig is accordingly able to be conveyed in a state in which the gripped unit has been gripped by the gripping member.

A conveyance jig of a third aspect is the conveyance jig of the first aspect or the second aspect, wherein a positioning portion, at which a positioning member engages, is formed at the base part.

In the conveyance jig of the third aspect, the position of the base part can be fixed by engaging the positioning member with the positioning portion formed in the base part. This thereby enables tasks to be performed on the base part in a stabilized state.

A circuit board manufacturing device of a fourth aspect includes an insulation layer fixing unit that fixes the insulation layer on the board, a circuit part fixing unit that fixes the circuit part on the insulation layer, the conveyance jig of any one aspect of the first aspect to the third aspect, and a conveyance unit that respectively conveys the conveyance jig to the insulation layer fixing unit and the circuit part fixing unit.

A circuit board manufacturing method of a fifth aspect employs the circuit board manufacturing device of the fourth aspect, and includes a first conveyance process of employing the conveyance jig and the conveyance unit to convey the board, in a state in which the insulation layer has been set, to the insulation layer fixing unit, a first fixing process of fixing the insulation layer to the board by pressing the insulation layer toward a side of the board, a second conveyance process of employing the conveyance jig and the conveyance unit to convey the board, in a state in which the circuit part is set on the insulation layer, to the circuit part fixing unit, and a second fixing process of fixing the circuit part to the insulation layer by pressing the circuit part toward the side of the board.

The circuit board manufacturing device of the fourth aspect may, for example, employ the manufacturing method of the fifth aspect. In the manufacturing method of the fifth aspect, firstly, a board is conveyed to the insulation layer fixing unit using the conveyance jig and the conveyance unit in a state in which the insulation layer has been set (first conveyance process). Next, the insulation layer is fixed to the board by pressing the insulation layer toward the side of the board (first fixing process). Next, the board is conveyed to the circuit part fixing unit using the conveyance jig and the conveyance unit in a state in which the circuit part has been set on the insulation layer (second conveyance process). Next, the insulation layer is fixed to the insulation layer by pressing the circuit part toward the side of the board (second fixing process). In the circuit board manufacturing device of the fourth aspect and the manufacturing method of the fifth aspect, boards having different shapes and dimensions to each other can be supported on the base part by varying the locations where the plural movement-restricting units engage with the base part. The circuit board manufacturing device of the fourth aspect and the manufacturing method of the fifth aspect are according able to accommodate plural specifications of circuit board.

### Advantageous Effects

The conveyance jig, circuit board manufacturing device, and circuit board manufacturing method of the present disclosure exhibit the excellent advantageous effect of enabling plural specifications of circuit board to be accommodated.

### BRIEF DESCRIPTION OF DRAWINGS

Fig. 1 is a perspective view illustrating a circuit board.
Fig. 2 is a cross-section illustrating a circuit board.
Fig. 3 is a block diagram illustrating part of a circuit board manufacturing device.
Fig. 4 is a block diagram illustrating another part of a circuit board manufacturing device.
Fig. 5 is a perspective view illustrating an insulation layer formed on a PET film.
Fig. 6 is a perspective view to explain processes in an insulation layer cutting unit.
Fig. 7 is a perspective view illustrating a common conveyance jig and a positioning jig.
Fig. 8 is a perspective view to explain processes in a first setting unit, and illustrates a state in which a board has been set on a common conveyance jig.
Fig. 9 is a perspective view to explain processes in a first setting unit, and illustrates a process in which an insulation layer and the like are set on a board.
Fig. 10 is a side view to explain processes by a first preheating unit.
Fig. 11 is a side view illustrating a device employed in a first pressing unit.
Fig. 12 is a plan view illustrating a thermopress section conveyance unit.
Fig. 13 is a side view cross-section illustrating a thermopress section and the like.
Fig. 14 is a plan view illustrating a reception jig.
Fig. 15 is a side view cross-section illustrating processes in which an insulation layer that has been set on a board is pressed toward the board side.
Fig. 16 is a side view to explain a first insulation layer fixing process.
Fig. 17 is a side view to explain a first insulation layer fixing process.
Fig. 18 is a side view to explain a second insulation layer fixing process.
Fig. 19 is a side view to explain a third insulation layer fixing process and a fourth insulation layer fixing process.
Fig. 20 is a side view to explain a third insulation layer fixing process and a fourth insulation layer fixing process.
Fig. 21 is a side view to explain a fifth insulation layer fixing process.
Fig. 22 is a side view to explain a sixth insulation layer fixing process and a seventh insulation layer fixing process.
Fig. 23 is a side view to explain processes by a first demount unit.
Fig. 24 is a side view to explain processes by a first cooling unit.
Fig. 25 is a perspective view to explain processes by a first stripping unit.
Fig. 26 is a perspective view to explain processes by a first inspection unit.
Fig. 27 is a perspective view to explain processes by a circuit part sticking unit.
Fig. 28 is a perspective view to explain processes in a second setting unit, and illustrates a process in which circuit parts and the like are set on a board.
Fig. 29 is a side view cross-section illustrating processes in which circuit parts set on a board are pressed toward the board side.
Fig. 30 is a side view to explain processes by a second demount unit.
Fig. 31 is a side view to explain processes by a second cooling unit.
Fig. 32 is a perspective view to explain processes by a second stripping unit.
Fig. 33 is a perspective view to explain processes by a second inspection unit.
Fig. 34A is a plan view illustrating a common conveyance jig in a state in which a single board can be set.
Fig. 34B is a cross-section illustrating a cross-section of one movement-restricting unit sectioned along line 34B-34B of Fig. 34A.
Fig. 34C is a cross-section illustrating a cross-section of one gripped unit sectioned along line 34C-34C of Fig. 34A.
Fig. 35 is a plan view illustrating a common conveyance jig in a state in which two boards can be set.

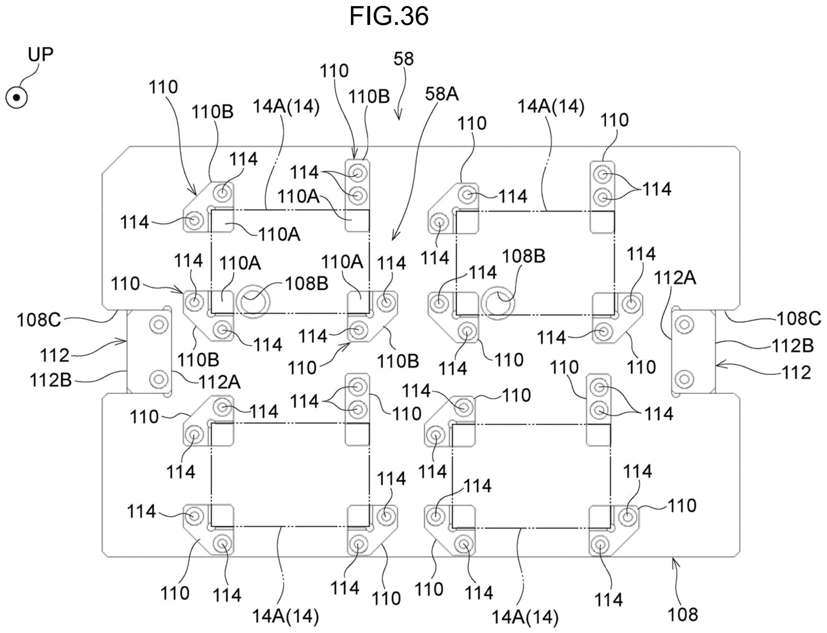

Fig. 36 is a plan view illustrating a common conveyance jig in a state in which four boards can be set.

### DESCRIPTION OF EMBODIMENTS

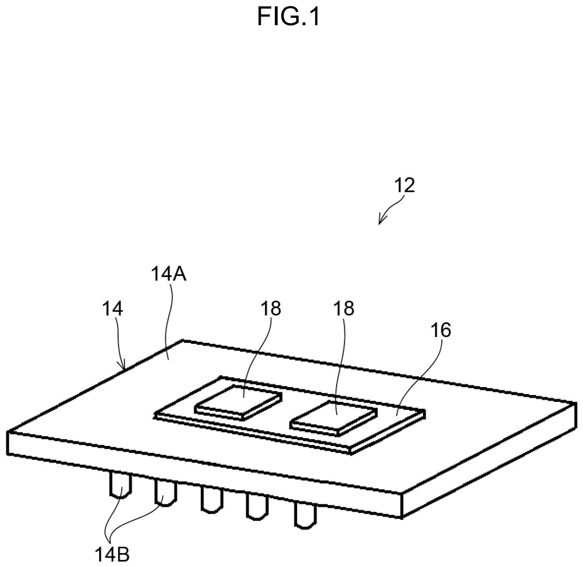

Firstly, description follows regarding a circuit board manufacturing device 10 and a circuit board manufacturing method according to an exemplary embodiment of the present disclosure, with reference to Fig. 1 to Fig. 33. Note that arrow UP in the drawings indicates an upward side of the circuit board manufacturing device 10. Firstly, an outline configuration of the circuit board 12 will be described, and next a circuit board manufacturing method will be described together with the configuration of the circuit board manufacturing device 10.

### Outline Configuration of Circuit Board 12

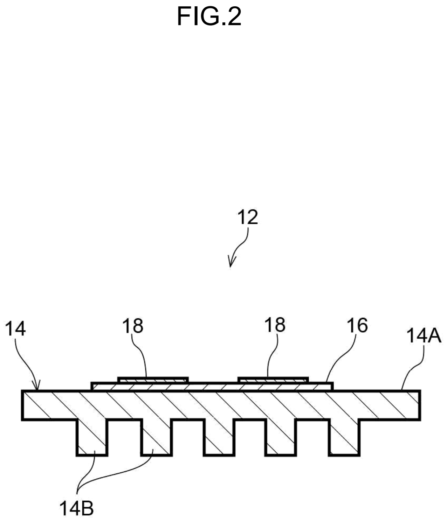

As illustrated in Fig. 1 and Fig. 2, the circuit board 12 includes a board 12, an insulation layer 16 fixed on the board 12, and circuit parts 18 fixed on the insulation layer 16.

The board 12 is formed from a metal material. The board 12 includes a plate shaped section 14A formed in a rectangular plate shape, and plural heat dissipation sections 14B that project out from the plate shaped section 14A. The insulation layer 16 and the circuit parts 18 are fixed, in a stacked state, to a thickness direction one-side face of the plate shaped section 14A. The plural heat dissipation sections 14B project out from a thickness direction other-side face of the plate shaped section 14A toward the opposite side to the plate shaped section 14A. The plural heat dissipation sections 14B are, as an example, formed in circular pillar shapes, and are arrayed regularly at a predetermined spacing from each other.

The insulation layer 16 is formed in a sheet shape from a material with electrical insulation properties. The insulation layer 16 secures insulation properties between the plate shaped section 14A of the board 12 and the circuit parts 18 by being interposed therebetween.

The circuit parts 18 are each formed in a rectangular plate shape from an electroconductive material. In the present exemplary embodiment, plural of the circuit parts 18 that have been formed so as to have a predetermined pattern are fixed on the insulation layer 16.

### Circuit Board Manufacturing Device 10 and Circuit Board Manufacturing Method

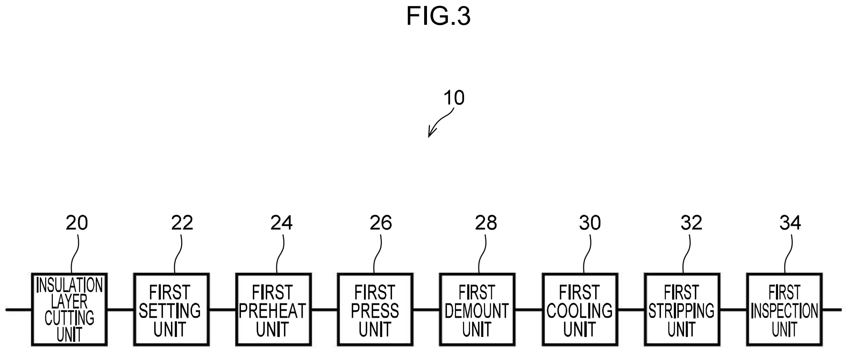

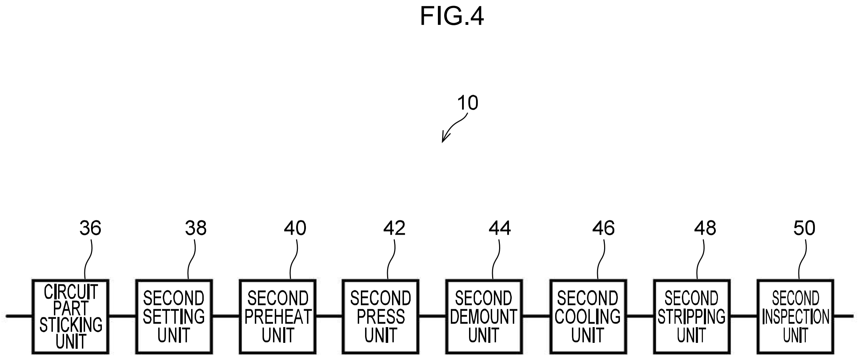

Fig. 3 and Fig. 4 are block diagrams schematically illustrating the circuit board manufacturing device 10 employed in the manufacture of the circuit board 12 (hereinafter simply referred to as "manufacturing device 10"). As illustrated in Fig. 3, the manufacturing device 10 includes an insulation layer cutting unit 20, a first setting unit 22, a first preheating unit 24, a first pressing unit 26, a first demount unit 28, a first cooling unit 30, a first stripping unit 32, and a first inspection unit 34. Moreover, as illustrated in Fig. 4, the manufacturing device 10 includes a circuit part sticking unit 36, a second setting unit 38, a second preheating unit 40, a second pressing unit 42, a second demount unit 44, a second cooling unit 46, a second stripping unit 48, and a second inspection unit 50.

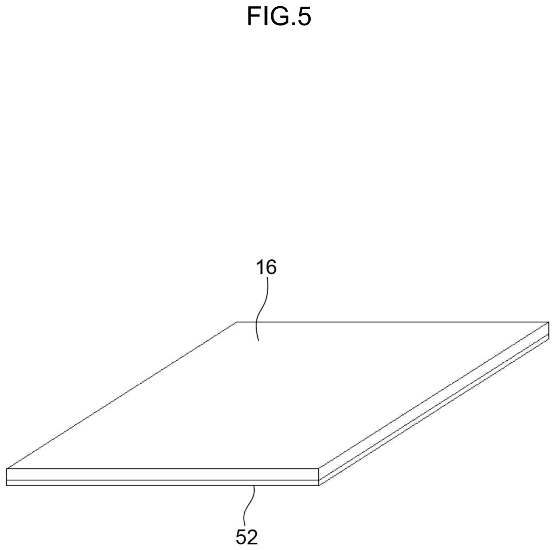

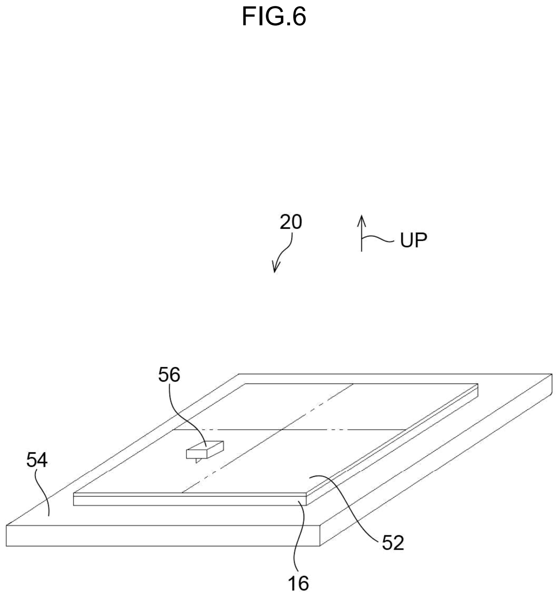

As illustrated in Fig. 3, Fig. 5, and Fig. 6, firstly, the insulation layer 16 is cut to a predetermined shape and dimensions in the insulation layer cutting unit 20. As illustrated in Fig. 5, the insulation layer 16 is formed in a sheet shape along a film 52 formed from polyethylene terephthalate (hereafter referred to as PET film 52). As illustrated in Fig. 6, the insulation layer cutting unit 20 includes a cutting jig 54 where the insulation layer 16 is placed together with the PET film 52, and a cutter 56 that cuts the insulation layer 16 placed on the cutting jig 54 together with the PET film 52. Then, in processes of the insulation layer cutting unit 20, firstly the insulation layer 16 is, together with the PET film 52, placed (set) on the cutting jig 54 in a state in which the insulation layer 16 faces downward with respect to the PET film 52. Next, the insulation layer 16 is, together with the PET film 52, cut to a predetermined shape and dimensions by moving the cutter 56 along a predetermined track on the cutting jig 54. Note that cutting locations are depicted in Fig. 6 by double-dashed broken lines. In the present exemplary embodiment, the insulation layer 16 is cut together with the PET film 52, and so distortion in the vicinity of cut portions of the insulation layer 16 is suppressed compared to cases in which the insulation layer 16 is cut as a single body. Note that all of the processes of the insulation layer cutting unit 20 may be performed automatically, or some or all of the processes of the insulation layer cutting unit 20 may be performed manually.

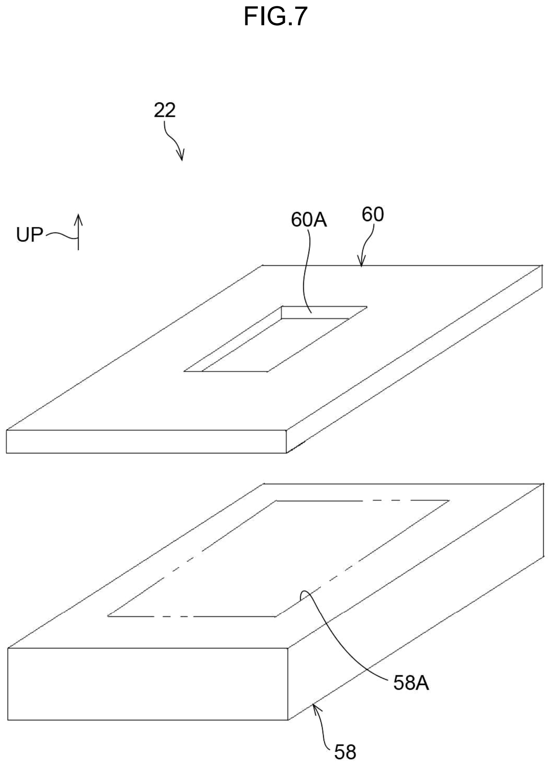

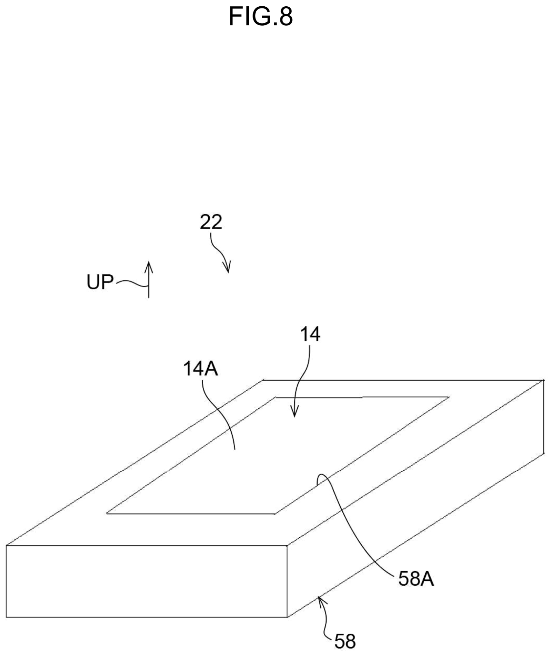

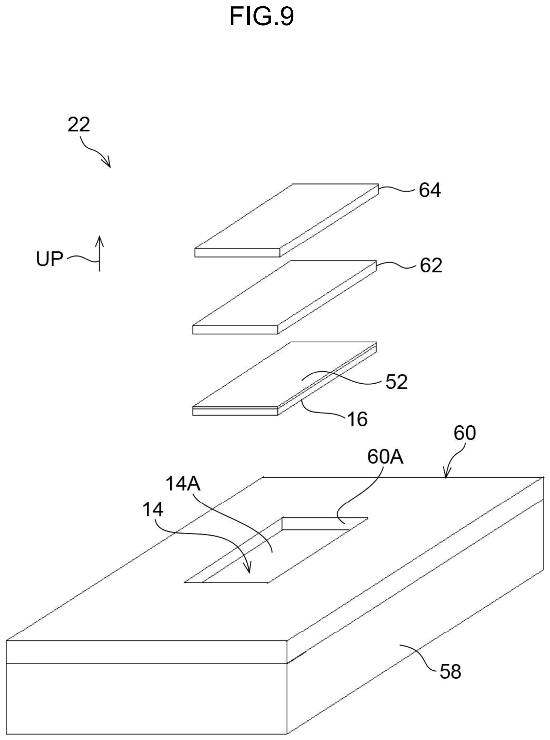

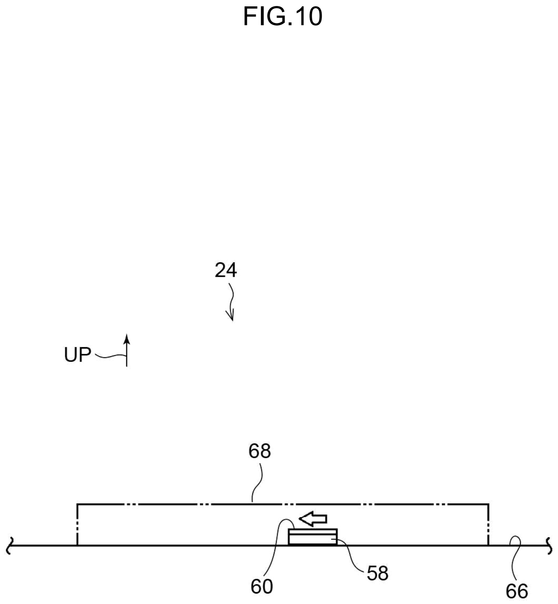

As illustrated in Fig. 3, Fig. 7, Fig. 8, and Fig. 9, in the first setting unit 22 the insulation layer 16 that has been cut to the predetermined shape and dimensions by the insulation layer cutting unit 20 is set on the board 12. As illustrated in Fig. 7, the first setting unit 22 employs a common conveyance jig 58 conveyed by a conveyance unit 66 (see Fig. 10), described later, and a positioning jig 60 that engages with the common conveyance jig 58. The common conveyance jig 58 serving as a conveyance jig includes a board setting section 58A where the board 12 is set in a fitted-in state. The positioning jig 60 is formed from a metal material similar to the common conveyance jig 58. A rectangular shaped positioning hole 60A is formed in the positioning jig 60 so as to pass through in an up-down direction. Then, movement of the positioning jig 60 in a horizontal direction (a direction orthogonal to the up-down direction) with respect to the common conveyance jig 58 is restricted by engaging the positioning jig 60 with the common conveyance jig 58 from above. Then, in processes of the first setting unit 22, firstly, as illustrated in Fig. 8, the board 12 is set on the board setting section 58A of the common conveyance jig 58 oriented with the plural heat dissipation sections 14B on the lower side thereof. Next, as illustrated in Fig. 9, the positioning jig 60 is engaged with the common conveyance jig 58 from above. In a state in which the positioning jig 60 is engaged with the common conveyance jig 58, a portion of the plate shaped section 14A of the board 12 to which the insulation layer 16 is to be fixed is exposed to the upper side through the positioning hole 60A. Next, an adhesive is coated onto the face of the insulation layer 16 that is on the opposite side to the PET film 52. Next, the insulation layer 16 is disposed inside the positioning hole 60A of the positioning jig 60 in a state in which the adhesive coated side of the insulation layer 16 is facing downward, and the insulation layer 16 is, together with the PET film 52, set on the plate shaped section 14A of the board 12. Next, a metal sheet 62 and piece of cardboard 64, which are set with shapes and dimensions corresponding to the shape and dimensions of the insulation layer 16 when viewed from above, are disposed inside the positioning hole 60A of the positioning jig 60, and the metal sheet 62 and the piece of cardboard 64 are set on the insulation layer 16 (on the PET film 52). Note that all of the processes of the first setting unit 22 may be performed automatically, or some or all of the processes of the first setting unit 22 may be performed manually.

As illustrated in Fig. 3 and Fig. 10, the board 12 and the insulation layer 16 are heated in the first preheating unit 24. As illustrated in Fig. 10, the first preheating unit 24 includes a heating oven 68 provided so as to surround the conveyance unit 66 that conveys the common conveyance jig 58. The temperature inside the heating oven 68 is maintained at a predetermined temperature. Then, in processes of the first preheating unit 24, the common conveyance jig 58 is moved inside the heating oven 68 by the common conveyance jig 58 being conveyed by the conveyance unit 66. The board 12 set on the common conveyance jig 58 and the insulation layer 16 and the like set on the board 12 are accordingly heated thereby.

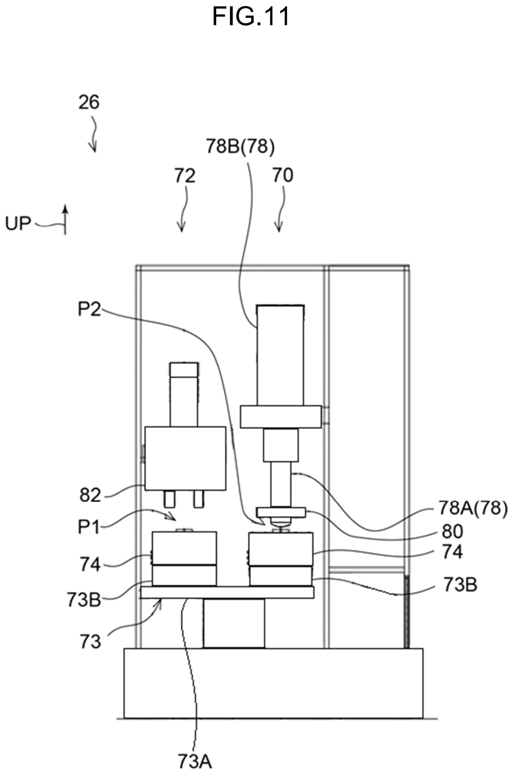

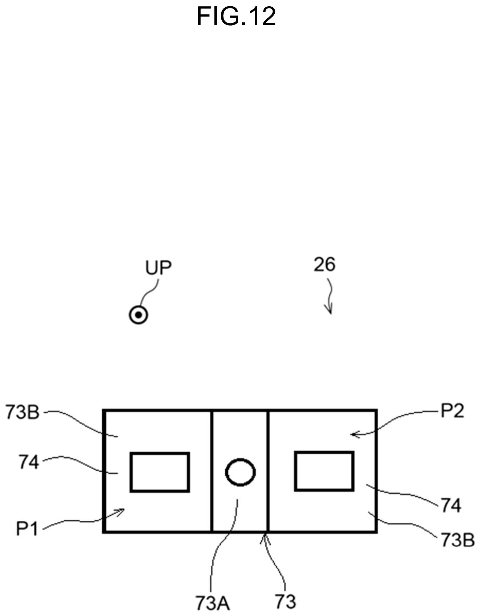

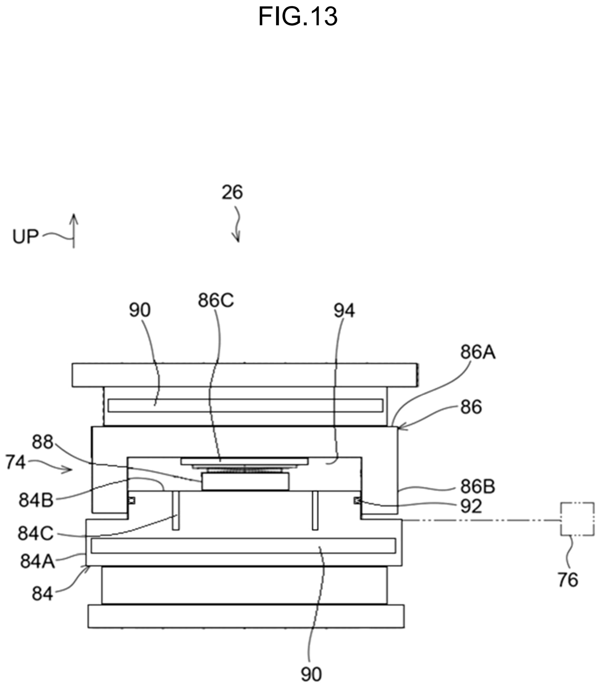

In the first pressing unit 26 serving as an insulation layer fixing unit, as illustrated in Fig. 3 and Fig. 11 to Fig. 22, the insulation layer 16 set on the board 12 is pressed toward the board 12 side. As illustrated in Fig. 11 and Fig. 12, the first pressing unit 26 includes a pressing unit main body 70 including a mechanism to press an upper mold 86, described later, toward a lower mold 84 side, a setup unit 72 provided adjacent to the pressing unit main body 70, and a thermopress section conveyance unit 73 that moves a thermopress section 74, described later, and the like between the pressing unit main body 70 and the setup unit 72. Moreover, as illustrated in Fig. 13, the first pressing unit 26 includes two of the thermopress sections 74 for setting the board 12 and the like thereon, and an air suction unit 76.

As illustrated in Fig. 11, the pressing unit main body 70 includes a hydraulic cylinder 78, and an upper mold engaging section 80 supported by the hydraulic cylinder 78. The upper mold engaging section 80, described later, is configured so as to detachably engage with the upper mold 86. The upper mold engaging section 80 is configured so as to press the upper mold 86 downward by operating the hydraulic cylinder 78. Note that the hydraulic cylinder 78 of the present exemplary embodiment is configured by a high pressure cylinder 78A and a low pressure cylinder 78B stacked on each other in the up-down direction.

The setup unit 72 includes an upper mold raising-lowering section 82 that raises and lowers the upper mold 86, described later. The upper mold 86 is able to be raised or lowered with respect to the lower mold 84 by operating the upper mold raising-lowering section 82.

As illustrated in Fig. 11 and Fig. 12, the thermopress section conveyance unit 73 includes a rotation section 73A that is rotatable about an axial direction aligned with the up-down direction, and two lower mold engaging sections 73B fixed to upper portions of the rotation section 73A. The two thermopress sections 74, described later, are configured so as to respectively engage with the two lower mold engaging sections 73B. This results in a configuration in which, by rotating the rotation section 73A, one of the lower mold engaging sections 73B is moved from the pressing unit main body 70 to the setup unit 72, and the other of the lower mold engaging sections 73B is moved from the setup unit 72 toward the pressing unit main body 70. Thereby, the thermopress section 74 on the one lower mold engaging section 73B is moved from the pressing unit main body 70 to the setup unit 72, and the thermopress section 74 on the other lower mold engaging section 73B is moved from the setup unit 72 to the pressing unit main body 70. Note that a position on the lower mold engaging section 73B disposed in the setup unit 72 is referred to as being a "setup position P1", and a position on the lower mold engaging section 73B disposed in the pressing unit main body 70 is referred to as being a "pressure application position P2".

The two thermopress sections 74 are configured similarly to each other, as illustrated in Fig. 13. Note that only the thermopress section 74 disposed on the pressing unit main body 70 side is illustrated in Fig. 13. The thermopress section 74 includes the lower mold 84, the upper mold 86 that engages with the lower mold 84, and a reception jig 88 that is fixed to the lower mold 84.

The lower mold 84 includes a lower plate section 84A fixed to the lower mold engaging section 73B, and a central protrusion 84B that projects upward from a horizontal direction central portion of the lower plate section 84A. The reception jig 88, described later, is fixed to the upper face of the central protrusion 84B. Moreover, a heater 90 for heating the lower mold 84 is provided in the lower plate section 84A. Furthermore, an O-ring 92 is mounted to the central protrusion 84B. A vacuum path 84C is formed in the lower plate section 84A and the central protrusion 84B, with one end side thereof opening onto the upper face of the central protrusion 84B, and the other end side thereof connected to the air suction unit 76, such as a vacuum pump or the like.

The upper mold 86 is disposed at the upper side with respect to the lower mold 84. The upper mold 86 includes an upper plate section 86A that detachably engages with the upper mold engaging section 80 and the upper mold raising-lowering section 82 (see Fig. 11), and a peripheral wall 86B that projects downward from horizontal direction end portions of the upper plate section 86A. The upper mold 86 is configured so as to engage with the lower mold 84 by moving the upper mold 86 toward the lower mold 84 side. In a state in which the upper mold 86 has engaged with the lower mold 84, the central protrusion 84B of the lower mold 84 is disposed inside the peripheral wall 86B of the upper mold 86. A sealed space 94 surrounding the reception jig 88 is thereby formed between the upper mold 86 and the lower mold 84. Note that in a state in which the upper mold 86 has engaged with the lower mold 84, a gap between the central protrusion 84B of the lower mold 84 and the peripheral wall 86B of the upper mold 86 is sealed by the O-ring 92. Moreover, the heater 90 for heating the upper mold 86 is provided in the upper plate section 86A. Furthermore, the upper mold 86 includes a pressure concentration section 86 that projects downward from a horizontal direction central portion of the upper plate section 86A.

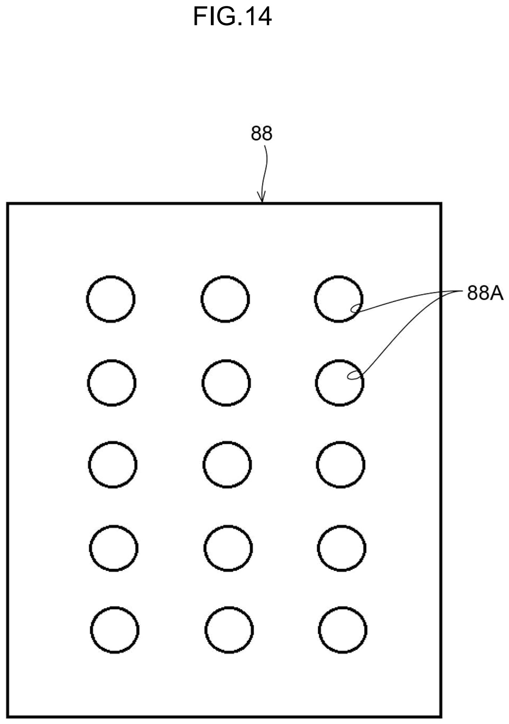

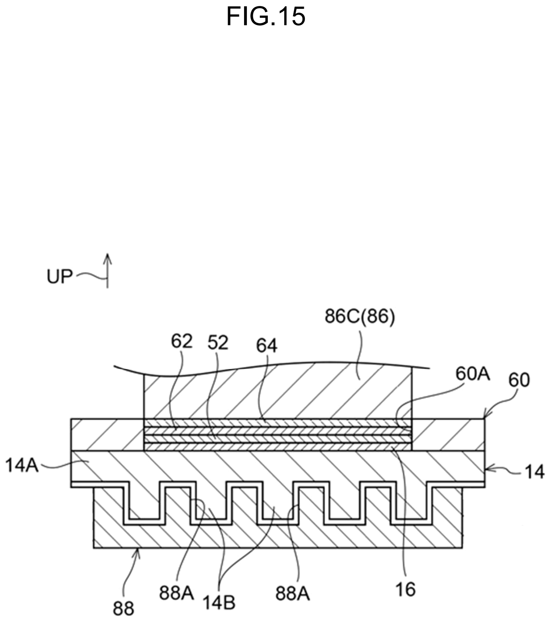

Fig. 14 illustrates the reception jig 88 in plan view, as viewed from above. The reception jig 88 is formed in a rectangular block shape. Moreover, there are plural insertion holes 88A opening upward formed in the reception jig 88. The plural insertion holes 88A are arrayed regularly at a predetermined spacing from each other so as to correspond to the plural heat dissipation sections 14B (see Fig. 1) of the board 12. Then, as illustrated in Fig. 15, the board 12 is set on the reception jig 88 in a state in which the plural heat dissipation sections 14B of the board 12 have been inserted into the plural insertion holes 88A. In the state in which the board 12 has been set on the reception jig 88, a lower face of the plate shaped section 14A (a face of the board 12 constituting bottom faces of the plural heat dissipation sections 14B) contacts the upper face of the reception jig 88.

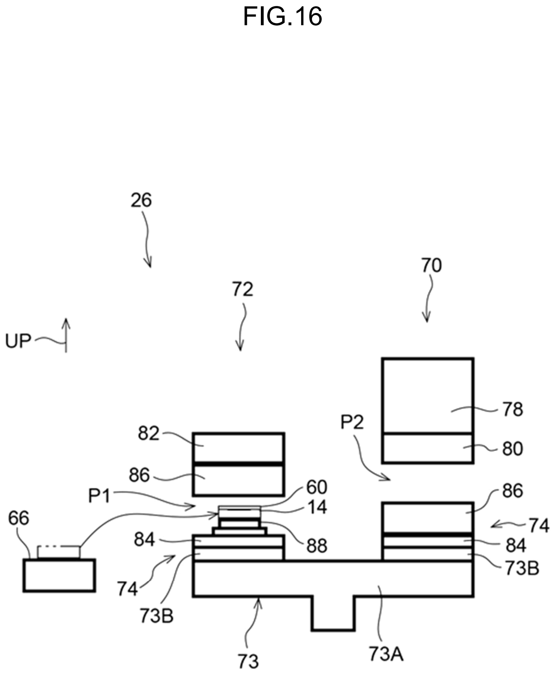

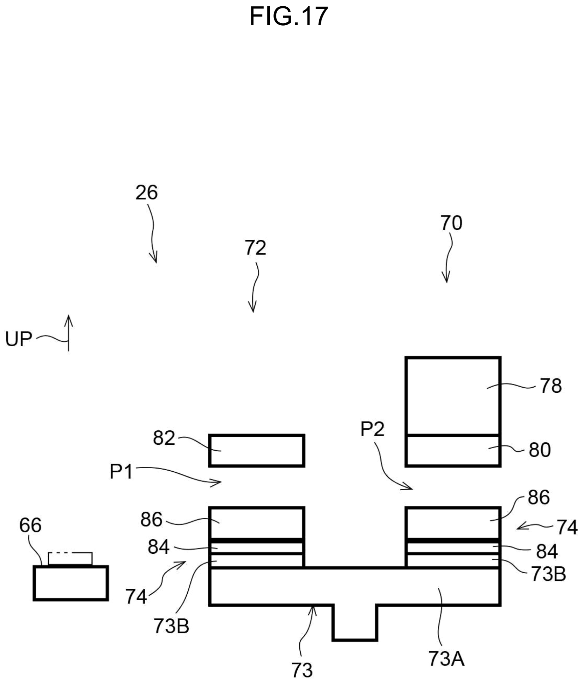

Then, as illustrated in Fig. 16, in processes of the first pressing unit 26, firstly the board 12 that has finished the processes by the first preheating unit 24 (has passed through the heating oven 68) is set on the thermopress section 74 disposed at the setup position P1. Note that the processes employing the common conveyance jig 58 and the conveyance unit 66 to convey the board 14 in a state set with the insulation layer 16 from the first setting unit 22 to the first pressing unit 26 are first conveyance processes. When the board 14 has been conveyed to the first pressing unit 26, the board 12, together with the positioning jig 60 and the like, is moved by operation of a non-illustrated manipulator, and the board 12 is set in the reception jig 88 disposed at the setup position P1. Next, as illustrated in Fig. 17, the upper mold 86 is engaged with the lower mold 84 at the setup position P1 by operating the upper mold raising-lowering section 82 (first insulation layer fixing process). The upper mold 86 and the lower mold 84 are heated so as to attain a predetermined temperature by the heaters 90 mentioned above. Moreover, the air suction unit 76 is operated when the upper mold 86 is engaged with the lower mold 84 at the setup position P1, and air inside the sealed space 94 between the upper mold 86 and the lower mold 84 is suctioned out. Namely, a vacuum is created inside the sealed space 94 between the upper mold 86 and the lower mold 84.

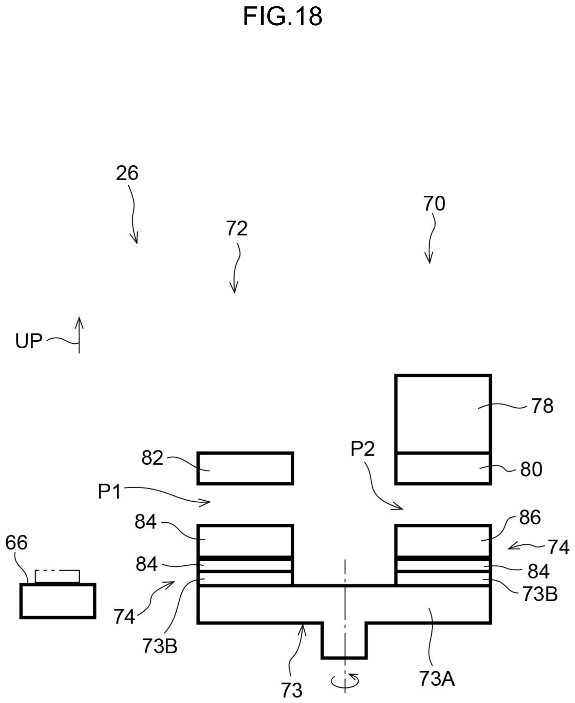

Next, as illustrated in Fig. 18, the thermopress section 74 disposed at the setup position P1 is moved to the pressure application position P2 side by rotating the rotation section 73A. When this occurs, the thermopress section 74 disposed at the pressure application position P2 is moved to the setup position P1 side (second insulation layer fixing process).

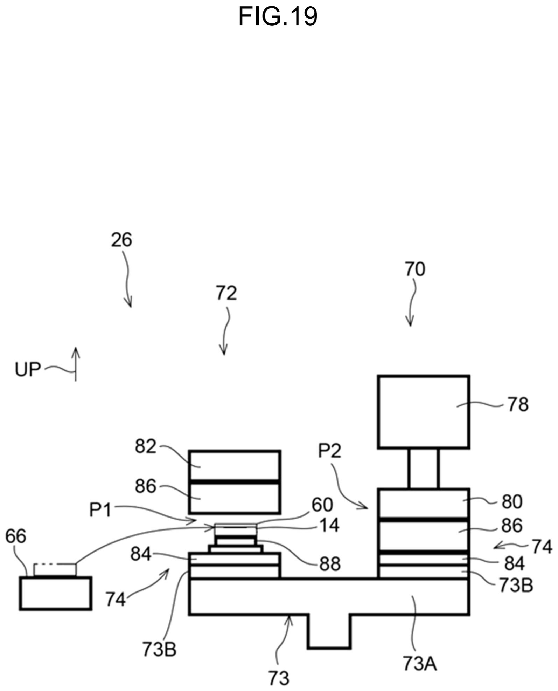

Next, as illustrated in Fig. 19, the upper mold engaging section 80 is engaged with the upper mold 86, and the upper mold 86 is pressed toward the lower mold 84 side at the pressure application position P2, thereby pressing the insulation layer 16 toward the board 12 side. The insulation layer 16 is thereby fixed to the board 12 (third insulation layer fixing process). Note that the third insulation layer fixing process is configured such that a state in which the insulation layer 16 is pressed toward the board 12 side is held for a predetermined period of time. Moreover, the upper mold 86 and the lower mold 84 are also heated by the heaters 90 in the third insulation layer fixing process, and also a vacuum is created inside the sealed space 94 between the upper mold 86 and the lower mold 84.

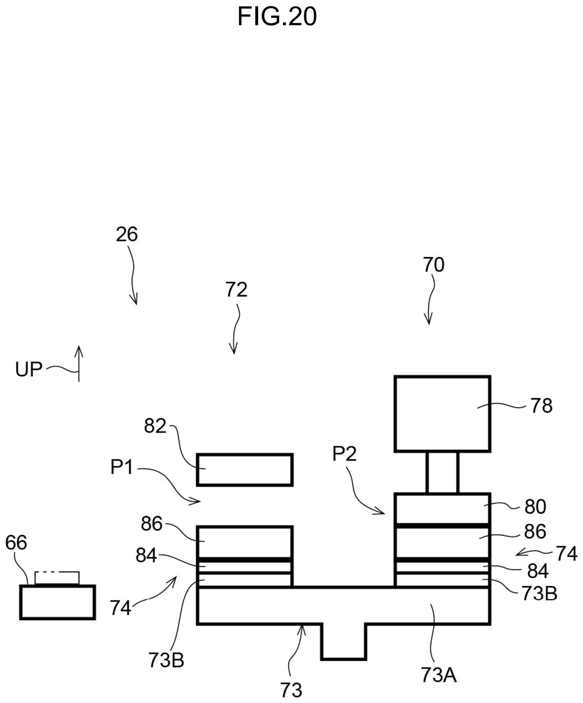

At the same time as (in parallel to) the third insulation layer fixing process, the board 12 that has finished the processes by the first preheating unit 24 (has passed through the heating oven 68) is set in the thermopress section 74 disposed at the setup position P1. Next, as illustrated in Fig. 20, by operating the upper mold raising-lowering section 82, the upper mold 86 is engaged with the lower mold 84 at the setup position P1 (fourth insulation layer fixing process). Moreover, when the upper mold 86 has been engaged with the lower mold 84 at the setup position P1, the air suction unit 76 is operated, and a vacuum is created inside the sealed space 94 between the upper mold 86 and the lower mold 84.

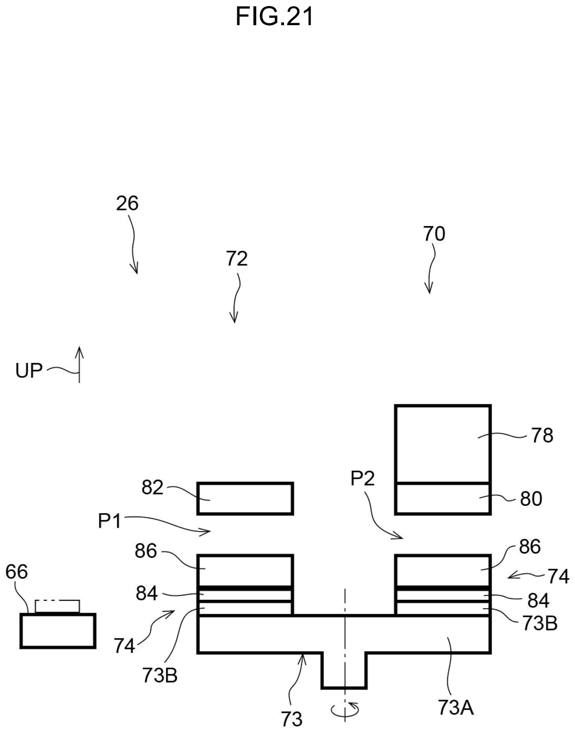

Next, as illustrated in Fig. 21, after engagement between the upper mold engaging section 80 and the upper mold 86 has been released, the thermopress section 74 that has finished the third insulation layer fixing process is moved from the pressure application position P2 to the setup position side by rotating the rotation section 73A. When this occurs, the thermopress section 74 that has finished the fourth insulation layer fixing process is moved from the setup position P1 to the pressure application position P2 side (fifth insulation layer fixing process).

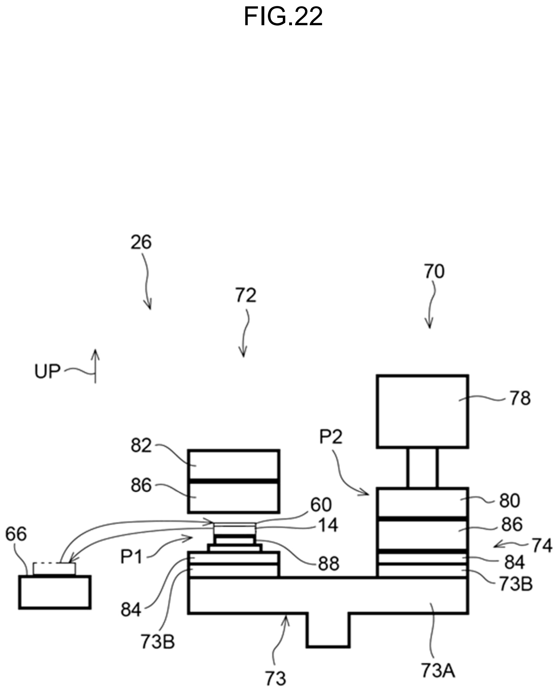

Next, as illustrated in Fig. 22, the insulation layer 16 is pressed toward the board 12 side by the upper mold engaging section 80 being engaged with the upper mold 86 and the upper mold 86 being pressed toward the lower mold 84 side at the pressure application position P2. The insulation layer 16 is thereby fixed to the board 12 (sixth insulation layer fixing process).

At the same time as (in parallel to) the sixth insulation layer fixing process, the board 12 with the insulation layer 16 affixed thereto is demounted from the thermopress section 74 disposed at the setup position P1. When this is performed, the board 12, together with the positioning jig 60 and the like, is moved by operating a non-illustrated manipulator, and the board 12 is demounted from the reception jig 88 disposed at the setup position P1. The board 12 demounted from the reception jig 88 is returned, together with the positioning jig 60 and the like, to the common conveyance jig 58 on the conveyance unit 66. Next, a board 12 that has finished the processes by the first preheating unit 24 (has passed through the heating oven 68) is set in the thermopress section 74 disposed at the setup position P1 (seventh insulation layer fixing process). In this manner, by repeatedly performing the first insulation layer fixing process to the seventh insulation layer fixing process, the boards 12 and the like that have finished the processes by the first preheating unit 24 are introduced one after another into the first pressing unit 26. Moreover, the boards 12 and the like that have been introduced into the first pressing unit 26 are fed out one after another toward the next process. Note that the first insulation layer fixing process to the seventh insulation layer fixing process that have been described above are a first fixing process to fix the insulation layer 16 to the board 14.

In the first pressing unit 26 of the manufacturing device 10 of the present exemplary embodiment, the fourth insulation layer fixing process can be performed at the same time as third insulation layer fixing process. Moreover, the seventh insulation layer fixing process can be performed at the same time as the sixth insulation layer fixing process. This thereby enables a waiting time prior to passing through processes to fix the board 12 and the insulation layer 16 together to be suppressed from being prolonged. More specifically, a task to demount the board 12 affixed with the insulation layer 16 from the thermopress section 74 can be performed at the setup position P1 side while the insulation layer 16 is being pressed toward the board 12 side at the pressure application position P2. Moreover, a board 12 prior to being affixed with the insulation layer 16 can be set in the thermopress section 74 at the setup position P1 side while the insulation layer 16 is being pressed toward the board 12 side at the pressure application position P2. Furthermore, the board 12 and the like prior to being affixed with the insulation layer 16 can be heated by the heaters 90 respectively provided to the upper mold 86 and the lower mold 84 at the setup position P1 side while the insulation layer 16 is being pressed toward the board 12 side at the pressure application position P2. Moreover, a vacuum can be created inside the sealed space 94 formed between the upper mold 86 and the lower mold 84 at the setup position P1 side while the insulation layer 16 is being pressed toward the board 12 side at the pressure application position P2. The present exemplary embodiment is accordingly able to reduce time waiting while nothing is being performed prior to introducing the board 12 and the like that has finished the processes by the first preheating unit 24 into the first pressing unit 26.

Moreover, in the present exemplary embodiment, as illustrated in Fig. 15, a configuration is adopted in which the board 12 is set in the reception jig 88 in a state in which the plural heat dissipation sections 14B of the board 12 have been inserted into the plural insertion holes 88A of the reception jig 88. In the state in which the board 12 has been set in the reception jig 88, the lower face of the plate shaped section 14A (the face of the board 12 constituting the bottom faces of the plural heat dissipation sections 14B) contacts the upper face of the reception jig 88. This thereby enables the bottom faces of the plural heat dissipation sections 14B of the board 12 to be supported by the upper face of the reception jig 88. As a result thereof, pressure application can be performed to the fixing locations of the insulation layer 16 even when employing the metal board 12 including the plural heat dissipation sections 14B formed with protruding profiles.

Moreover, due to the pressure concentration section 86 of the upper mold 86 being inserted into the positioning hole 60A of the positioning jig 60, the present exemplary embodiment is configured such that portions on the plate shaped section 14A of the board 12 where the insulation layer 16 is placed are pressed in a concentrated manner. This thereby enables the portions where the insulation layer 16 is placed on the plate shaped section 14A of the board 12 to be pressed in a pinpoint manner.

Moreover, the present exemplary embodiment is configured such that the pressure concentration section 86 of the upper mold 86 presses the portion where the insulation layer 16 is placed on the plate shaped section 14A of the board 12 through the piece of cardboard 64 and the metal sheet 62. This thereby enables the portions where the insulation layer 16 is placed on the plate shaped section 14A of the board 12 to be pressed uniformly. Moreover, by providing the metal sheet 62 between the piece of cardboard 64 and the insulation layer 16 (the PET film 52), irregularities in the piece of cardboard 64 can be prevented from being transferred to the insulation layer 16.

Moreover, in the present exemplary embodiment, air inside the sealed space 94 formed between the upper mold 86 and the lower mold 84 can be suctioned out by the air suction unit 76. This thereby enables a vacuum to be created at the periphery of the fixing locations of the insulation layer 16 faster than configurations in which the air in a space outside the lower mold 84 and the upper mold 86 is also suctioned out in order to suction out the air from inside the sealed space 94 formed between the upper mold 86 and the lower mold 84.

Moreover, in the present exemplary embodiment, the board 12 and the like is heated in the processes of the first preheating unit 24. This thereby enables the time for heating the board 12 and the like in the processes of the first pressing unit 26 to be shortened.

Note that all the above-described processes of the first pressing unit 26 may be performed automatically, or some of the processes of the first pressing unit 26 may be performed manually.

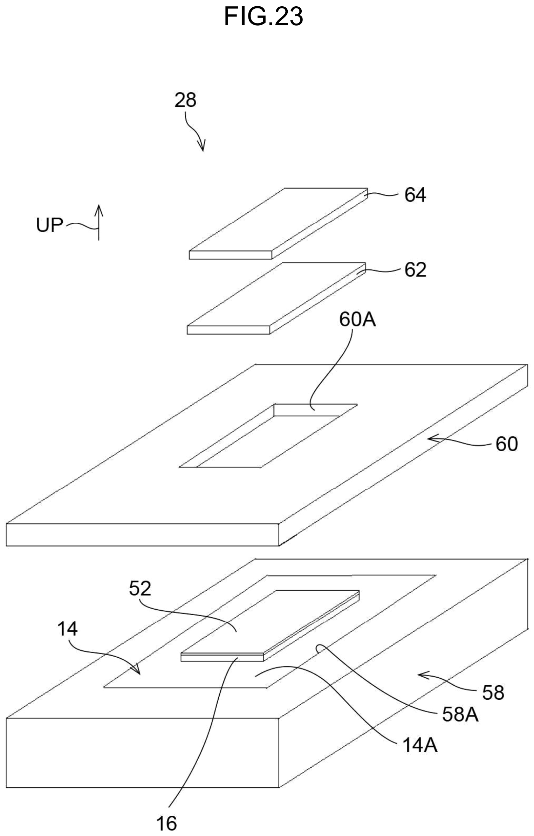

As illustrated in Fig. 3 and Fig. 23, in the first demount unit 28, the positioning jig 60 is demounted from the common conveyance jig 58 that has been sent in from the first pressing unit 26. Moreover, in the first demount unit 28, the metal sheet 62 and the piece of cardboard 64 that have been set on the insulation layer 16 are demounted. Note that all the processes of the first demount unit 28 may be performed automatically, or some or all of the processes of the first demount unit 28 may be performed manually.

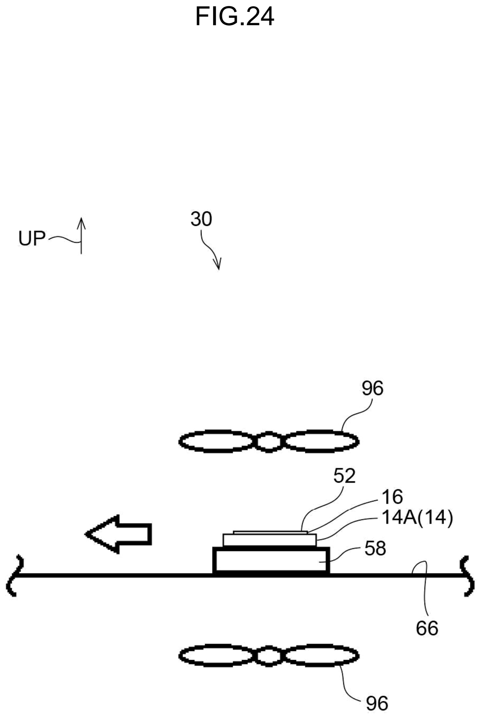

As illustrated in Fig. 3 and Fig. 24, the board 12 and the insulation layer 16 are cooled in the first cooling unit 30. As illustrated in Fig. 24, the first cooling unit 30 includes fans 96 respectively provided at an upper side and a lower side of the conveyance unit 66 that conveys the common conveyance jig 58. By the processes of the first cooling unit 30, the common conveyance jig 58 is conveyed by the conveyance unit 66, and the common conveyance jig 58 passes between the upper and lower fans 96. The board 12 set on the common conveyance jig 58 and the insulation layer 16 that has been fixed onto the board 12 are cooled thereby.

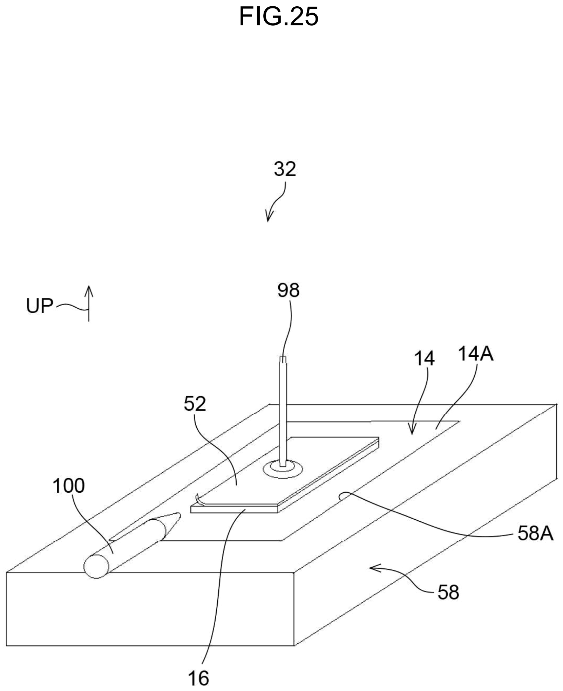

As illustrated in Fig. 3 and Fig. 25, the PET film 52 is removed from the insulation layer 16 in the first stripping unit 32. As illustrated in Fig. 25, the first stripping unit 32 includes a suction part 98 that suctions the PET film 52, and a nozzle 100 that ejects compressed air between the PET film 52 and the insulation layer 16. Then, in the processes of the first stripping unit 32, firstly a horizontal direction central portion of the PET film 52 is suctioned by the suction part 98. Next, the suction part 98 is moved while continuing to eject compressed air from the nozzle 100 to in between the PET film 52 and the insulation layer 16. The PET film 52 is thereby stripped from the insulation layer 16. Note that the PET film 52 that has been stripped from the insulation layer 16 is carried by the suction part 98 and thrown away into a specific container. Note that all the processes of the first stripping unit 32 may be performed automatically, or some or all of the processes of the first stripping unit 32 may be performed manually.

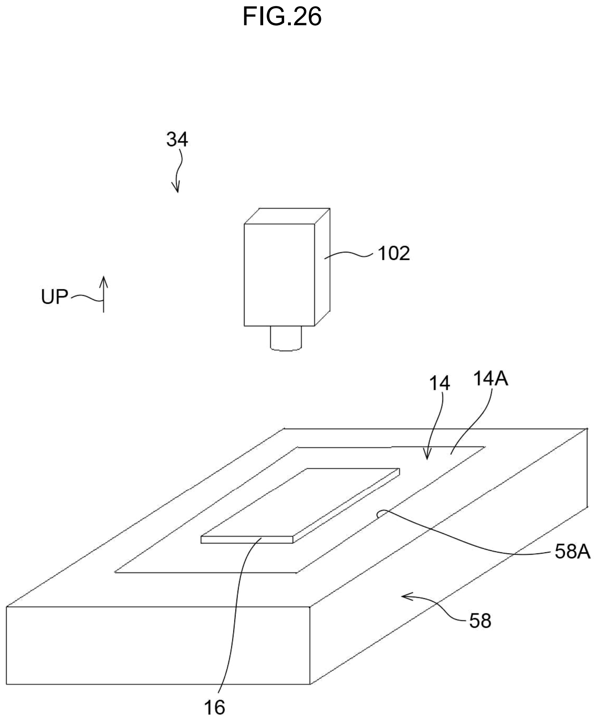

As illustrated in Fig. 3 and Fig. 26, inspection is performed in the first inspection unit 34 as to whether or not the insulation layer 16 is fixed to a predetermined position on the board 12. As illustrated in Fig. 26, the first inspection unit 34 includes a camera 102. Then, in the processes of the first inspection unit 34, inspection is performed as to whether or not the insulation layer 16 is fixed to a predetermined position on the board 12 by comparing inspection data with an image of the board 12 and the insulation layer 16 captured by the camera 102. In cases in which the output inspection result is that the insulation layer 16 is fixed to the predetermined position on the board 12, the board 12 affixed with the insulation layer 16 is conveyed toward the next process. On the other hand, in cases in which the output inspection result is that the insulation layer 16 is not fixed to the predetermined position on the board 12, the board 12 affixed with the insulation layer 16 is discarded without going toward the next process. Note that all the processes of the first inspection unit 34 may be performed automatically, or some or all of the processes of the first inspection unit 34 may be performed manually.

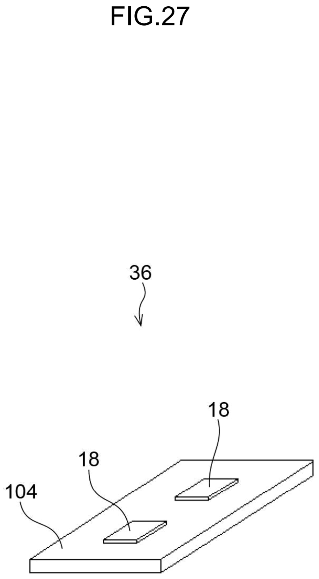

As illustrated in Fig. 4 and Fig. 27, the circuit parts 18 are stuck to a urethane sheet 104 by the circuit part sticking unit 36. As illustrated in Fig. 27, the shape and dimensions of the urethane sheet 104 when viewed along the thickness direction are set corresponding to the shape and dimensions of the insulation layer 16. An adhesive layer capable of sticking the circuit parts 18 is formed to a one-side face of the urethane sheet 104. Then, in the processes of the circuit part sticking unit 36, the circuit parts 18 are stuck to predetermined positions on the face of the urethane sheet 104 formed with the adhesive layer. The circuit parts 18 are thereby fixed to the urethane sheet 104. Note that all the processes of the circuit part sticking unit 36 may be performed automatically, or some or all of the processes of the circuit part sticking unit 36 may be performed manually.

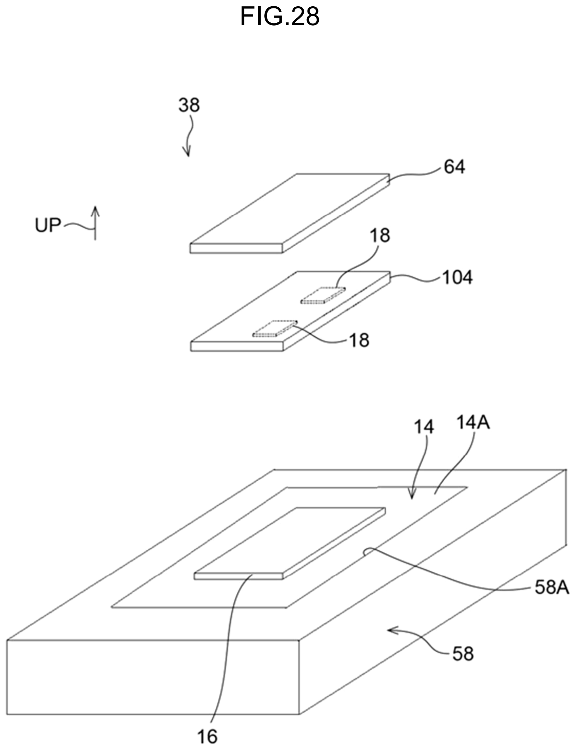

As illustrated in Fig. 4 and Fig. 28, in the second setting unit 38, the circuit parts 18 fixed to the urethane sheet 104 are set on the insulation layer 16 which has been fixed to the board 12.

In the processes of the second setting unit 38, a face of the circuit parts 18 on the opposite side to the urethane sheet 104 is coated in an adhesive. Alternatively, adhesive is coated onto portions of the insulation layer 16 where the circuit parts 18 are to be fixed. Next, the circuit parts 18 are, together with the urethane sheet 104, set on the insulation layer 16 in a state in which the faces of the circuit parts 18 on the opposite side to the urethane sheet 104 are facing downward. Next, the piece of cardboard 64 is set on the urethane sheet 104. Note that all the processes of the second setting unit 38 may be performed automatically, or some or all of the processes of the second setting unit 38 may be performed manually.

As illustrated in Fig. 4, the board 12, the insulation layer 16, and the circuit parts 18 are heated by the second preheating unit 40. Note that the processes of the second preheating unit 40 are similar processes to the processes of the first preheating unit 24. Namely, in the processes of the second preheating unit 40, the common conveyance jig 58 is moved inside the heating oven 68 by the common conveyance jig 58 being conveyed by the conveyance unit 66 (see Fig. 10). The board 12, the insulation layer 16, and the circuit parts 18 and the like that have been set on the common conveyance jig 58 are thereby heated.

As illustrated in Fig. 4, the circuit parts 18 that have been set on the insulation layer 16 are pressed toward the board 12 side in the second pressing unit 42 serving as a circuit part fixing unit. In the processes in the second pressing unit 42, similarly to in the processes in the first pressing unit 26, a pressing unit main body 70, a setup unit 72, a thermopress section conveyance unit 73, two thermopress sections 74, and an air suction unit 76 are employed as illustrated in Fig. 11 to Fig. 14. Each of the processes in the second pressing unit 42 is a process similar to the respective process in the first pressing unit 26. This means that description of each of the processes in the second pressing unit 42 will be performed using the same diagrams to the diagrams employed when describing each of the processes in the first pressing unit 26.

As illustrated in Fig. 16, in the processes in the second pressing unit 42, firstly, a board 12 that has finished the processes by the second preheating unit 40 (passed through the heating oven 68) is set in the thermopress section 74 disposed at the setup position P1. Note that processes employing the common conveyance jig 58 and the conveyance unit 66 to convey the board 14 in a state with the circuit parts 18 set on the insulation layer 16 from the second setting unit 38 to the second pressing unit 42 are second conveyance processes. When the board 14 has been conveyed to the second pressing unit 42, the board 12 is set on the reception jig 88 disposed at the setup position P1 by operating a non-illustrated manipulator. Next, as illustrated in Fig. 17, the upper mold 86 is engaged with the lower mold 84 at the setup position P1 by operating the upper mold raising-lowering section 82 (first circuit part fixing process). The upper mold 86 and the lower mold 84 are heated so as to attain a predetermined temperature by the heaters 90 described above. Moreover, when the upper mold 86 has been engaged with the lower mold 84 at the setup position P1, the air suction unit 76 is operated, and air is suctioned out from inside the sealed space 94 between the upper mold 86 and the lower mold 84. Namely, a vacuum is created inside the sealed space 94 between the upper mold 86 and the lower mold 84.

Next, as illustrated in Fig. 18, the thermopress section 74 disposed at the setup position P1 is moved to the pressure application position P2 side by rotating the rotation section 73A. When doing so, the thermopress section 74 disposed at the pressure application position P2 is moved to the setup position P1 side (second circuit part fixing process).

Next, as illustrated in Fig. 19, the upper mold engaging section 80 is engaged with the upper mold 86, and the circuit parts 18 that have been set on the insulation layer 16 are pressed toward the board 12 side by pressing the upper mold 86 toward the lower mold 84 side at the pressure application position P2. The circuit parts 18 are thereby fixed to the insulation layer 16 (third circuit part fixing process). Note that the third circuit part fixing process is configured such that a state in which the circuit parts 18 are pressed toward the board 12 side is held in for a predetermined period of time. Moreover, the third circuit part fixing process is configured such that the circuit parts 18 are pressed toward the board 12 side with a lower pressure than the pressure applied in the third insulation layer fixing process described above. In order to achieve this, for example, the high pressure cylinder 78A may be operated alone in the third insulation layer fixing process, and the low pressure cylinder 78B may be operated alone in the third circuit part fixing process. Moreover, the third circuit part fixing process is also configured such that the upper mold 86 and the lower mold 84 are heated by the heaters 90, and a vacuum is created inside the sealed space 94 between the upper mold 86 and the lower mold 84.

At the same time as (in parallel to) the third circuit part fixing process, the board 12 that has finished the processes by the second preheating unit 40 (has passed through the heating oven 68) is set in the thermopress section 74 disposed at the setup position P1. Next, as illustrated in Fig. 20, the upper mold 86 is engaged with the lower mold 84 at the setup position P1 by operating the upper mold raising-lowering section 82 (fourth circuit part fixing process). Moreover, when the upper mold 86 has been engaged with the lower mold 84 at the setup position P1, the air suction unit 76 is operated, and a vacuum is created inside the sealed space 94 formed between the upper mold 86 and the lower mold 84.

Next, as illustrated in Fig. 21, after the engagement between the upper mold engaging section 80 and the upper mold 86 has been released, the thermopress section 74 that has finished the third circuit part fixing process is moved from the pressure application position P2 to the setup position side by rotating the rotation section 73A. When doing so, the thermopress section 74 that has finished the fourth circuit part fixing process is moved from the setup position P1 to the pressure application position P2 side (fifth circuit part fixing process).

Next, as illustrated in Fig. 22, the upper mold engaging section 80 is engaged with the upper mold 86, and the circuit parts 18 that have been set on the insulation layer 16 are pressed toward the board 12 side by pressing the upper mold 86 toward the lower mold 84 side at the pressure application position P2. The circuit parts 18 are thereby fixed to the insulation layer 16 (sixth circuit part fixing process).

At the same time as (in parallel to) the sixth circuit part fixing process, the board 12 in a state in which the circuit parts 18 have been fixed on the insulation layer 16 is demounted from the thermopress section 74 disposed at the setup position P1. When doing so, the board 12 is demounted from the reception jig 88 disposed at the setup position P1 by operating a non-illustrated manipulator. The board 12 demounted from the reception jig 88 is returned again to the common conveyance jig 58 on the conveyance unit 66. Next, the board 12 that has finished the processes by the second preheating unit 40 (has passed through the heating oven 68) is set in the thermopress section 74 disposed at the setup position P1 (seventh circuit part fixing process). In this manner, by repeatedly performing the first circuit part fixing process to the seventh circuit part fixing process, the boards 12 and the like that have finished the processes by the second preheating unit 40 are introduced one after another into the second pressing unit 42. Moreover, the board 12 and the like that have been introduced into the second pressing unit 42 are fed out one after another toward the next process. Note that the first circuit part fixing process to the seventh circuit part fixing process as described above are a second fixing process to fix the circuit parts 18 to the insulation layer 16.

In the second pressing unit 42 of the manufacturing device 10 of the present exemplary embodiment, the fourth circuit part fixing process can be performed at the same time as the third circuit part fixing process. Moreover, the seventh circuit part fixing process can be performed at the same time as the sixth circuit part fixing process. This thereby enables the waiting time prior to passing through processes to fix the circuit parts 18 and the insulation layer 16 to be suppressed from being prolonged. More specifically, a task to demount the board 12 having the circuit parts 18 fixed on the insulation layer 16 from the thermopress section 74 can be performed at the setup position P1 side while the circuit parts 18 are being pressed toward the board 12 side at the pressure application position P2. Moreover, the board 12 that has the circuit parts 18 set on the insulation layer 16 can be set in the thermopress section 74 at the setup position P1 side while the circuit parts 18 are being pressed toward the board 12 side at the pressure application position P2. Furthermore, the board 12 and the like having the circuit parts 18 set on the insulation layer 16 can be heated by the heaters 90 respectively provided to the upper mold 86 and the lower mold 84 at the setup position P1 side while the circuit parts 18 are being pressed toward the board 12 side at the pressure application position P2. Moreover, a vacuum can be created inside the sealed space 94 formed between the upper mold 86 and the lower mold 84 at the setup position P1 side while the circuit parts 18 are being pressed toward the board 12 side at the pressure application position P2. In this manner, the present exemplary embodiment is able to shorten the time waiting while nothing is being performed prior to introducing the board 12 and the like that have finished the processes by the second preheating unit 40 into the second pressing unit 42.

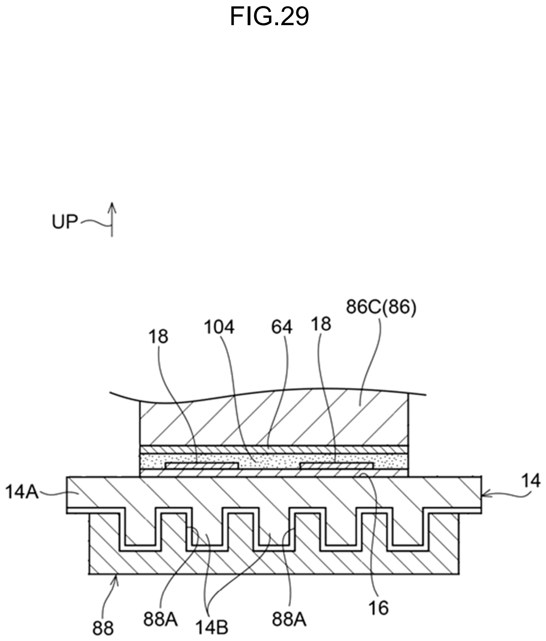

Moreover, the present exemplary embodiment is configured such that, as illustrated in Fig. 29, the board 12 is set in the reception jig 88 in a state in which the plural heat dissipation sections 14B of the board 12 are respectively inserted into the plural insertion holes 88A of the reception jig 88. In the state in which the board 12 has been set in the reception jig 88, the lower face of the plate shaped section 14A (the face of the board 12 constituting the bottom faces of the plural heat dissipation sections 14B) contacts the upper face of the reception jig 88. This thereby enables the bottom faces of the plural heat dissipation sections 14B of the board 12 to be supported by the upper face of the reception jig 88. As a result thereof, pressure application can be performed at the fixing locations of the circuit parts 18 even when employing the metal board 12 including the plural heat dissipation sections 14B formed with protruding profiles.

Moreover, the present exemplary embodiment is configured such that the pressure concentration section 86 of the upper mold 86 concentrates pressing at the portion where the circuit parts 18 are set. This thereby enables the portions where the circuit parts 18 have been set to be pressed in a pinpoint manner.

Moreover, the present exemplary embodiment is configured such that the pressure concentration section 86 of the upper mold 86 presses the portions where the circuit parts 18 are set through the piece of cardboard 64 and the urethane sheet 104. When the urethane sheet 104 has been pressed toward the board 12 side through the piece of cardboard 64, part of the urethane sheet 104 contacts the insulation layer 16 and also presses the insulation layer 16 downward. This thereby enables locations of the insulation layer 16 where the circuit parts 18 have not been fixed to be suppressed from rising up. Moreover, adhesive overhanging from between the insulation layer 16 and the circuit parts 18 can be absorbed by the urethane sheet 104.

Moreover, in the present exemplary embodiment, the air from inside the sealed space 94 formed between the upper mold 86 and the lower mold 84 can be suctioned out by the air suction unit 76. This thereby enables a vacuum to be created at the periphery of the fixing locations of the circuit parts 18 faster than configurations in which the air in a space outside the lower mold 84 and the upper mold 86 is also suctioned in order to suction out the air from inside the sealed space 94 formed between the upper mold 86 and the lower mold 84.

Moreover, in the present exemplary embodiment, the board 12 and the like are heated by the processes of the second preheating unit 40. This thereby enables the time for heating the board 12 and the like in the processes of the second pressing unit 42 to be shortened.

Note that all the processes by the second pressing unit 42 described above may be performed automatically, or some of the processes of the second pressing unit 42 may be performed manually.

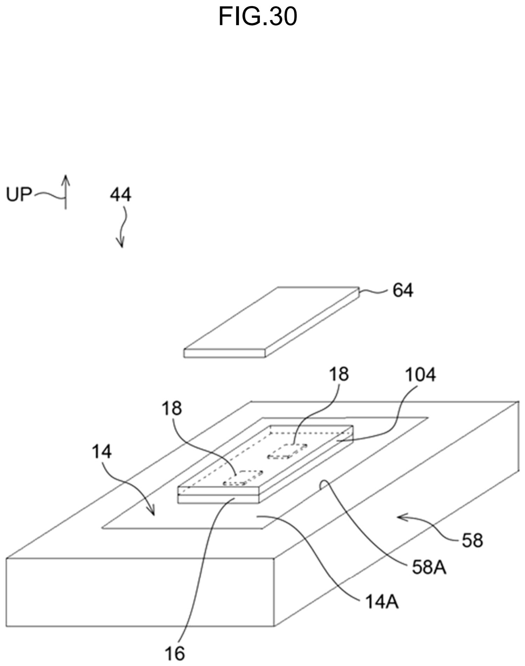

As illustrated in Fig. 4 and Fig. 30, the piece of cardboard 64 that has been set on the urethane sheet 104 is demounted in the second demount unit 44. Note that all the processes of the second demount unit 44 may be performed automatically, or some or all of the processes of the second demount unit 44 may be performed manually.

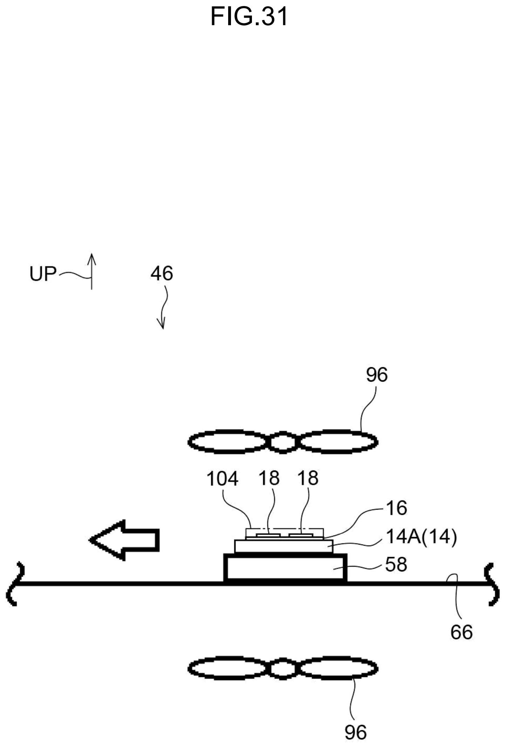

As illustrated in Fig. 4 and Fig. 31, the board 12, the insulation layer 16, and the circuit parts 18 are cooled in the second cooling unit 46. As illustrated in Fig. 31, in the processes of the second cooling unit 46, the common conveyance jig 58 passes through between the upper and lower fans 96 by the common conveyance jig 58 being conveyed by the conveyance unit 66. The board 12 that has been set on the common conveyance jig 58, the insulation layer 16 that has been fixed onto the board 12, and the circuit parts 18 that have been fixed onto the insulation layer 16, are cooled thereby.

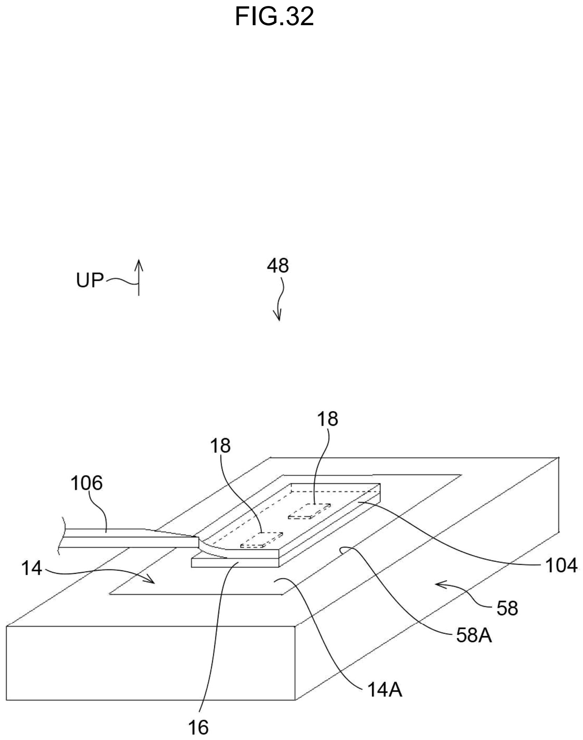

As illustrated in Fig. 4 and Fig. 32, the urethane sheet 104 is removed in the second stripping unit 48. As illustrated in Fig. 32, the second stripping unit 48 includes a gripper section 106 for gripping the urethane sheet 104. In the processes of the second stripping unit 48, firstly the gripper section 106 grips an end portion of the urethane sheet 104. Next, the gripper section 106 is moved with the end portion of the urethane sheet 104 in a gripped state. The urethane sheet 104 is thereby stripped from the circuit parts 18 and the insulation layer 16. Note that the urethane sheet 104 that has been stripped from the circuit parts 18 and the insulation layer 16 is carried by the gripper section 106 and thrown away into a specific container. Note that all the processes by the second stripping unit 48 may be performed automatically, or some or all of the processes of the second stripping unit 48 may be performed manually.

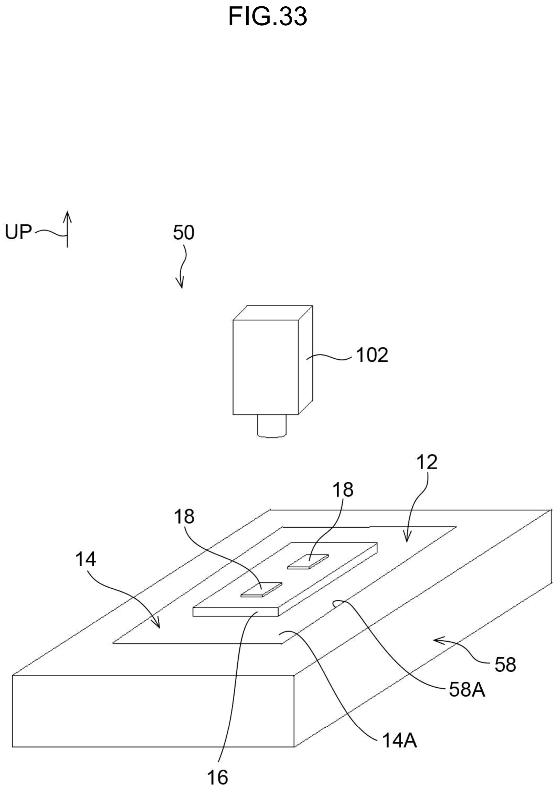

As illustrated in Fig. 4 and Fig. 33, in the second inspection unit 50, inspection is performed as to whether or not the circuit parts 18 are fixed to predetermined positions on the board 12. As illustrated in Fig. 33, in the processes of the second inspection unit 50, inspection is performed as to whether or not the circuit parts 18 are fixed to predetermined positions on the board 12 by comparing inspection data of an image of the board 12, the insulation layer 16, and the circuit parts 18 captured by the camera 102. In cases in which the output inspection result is that the circuit parts 18 are fixed to the predetermined positions on the board 12, the board 12 having the circuit parts 18 fixed onto the insulation layer 16 (the circuit board 12) is shipped as a product. On the other hand, in cases in which the output inspection result is that the circuit parts 18 are not fixed to the predetermined positions on the board 12, the board 12 having the circuit parts 18 fixed to the insulation layer 16 (the circuit board 12) is discarded and not shipped as a product. Note that all the processes by the second inspection unit 50 may be performed automatically, or some or all of the processes of the second inspection unit 50 may be performed manually.

The circuit board 12 illustrated in Fig. 1 and Fig. 2 is manufactured through the respective processes described above.

Note that details regarding the manufacturing device 10 and the respective processes that have been described above may be changed depending on the configuration of the circuit board 12.

Moreover, the insulation layer cutting unit 20, the first setting unit 22, the first preheating unit 24, the first pressing unit 26, the first demount unit 28, the first cooling unit 30, the first stripping unit 32, and the first inspection unit 34 illustrated in Fig. 3, and the circuit part sticking unit 36, the second setting unit 38, the second preheating unit 40, the second pressing unit 42, the second demount unit 44, the second cooling unit 46, the second stripping unit 48, and the second inspection unit 50 illustrated in Fig. 4, may be common equipment, or each may be equipment provided independently.

### Detailed Configuration of Common Conveyance Jig 58

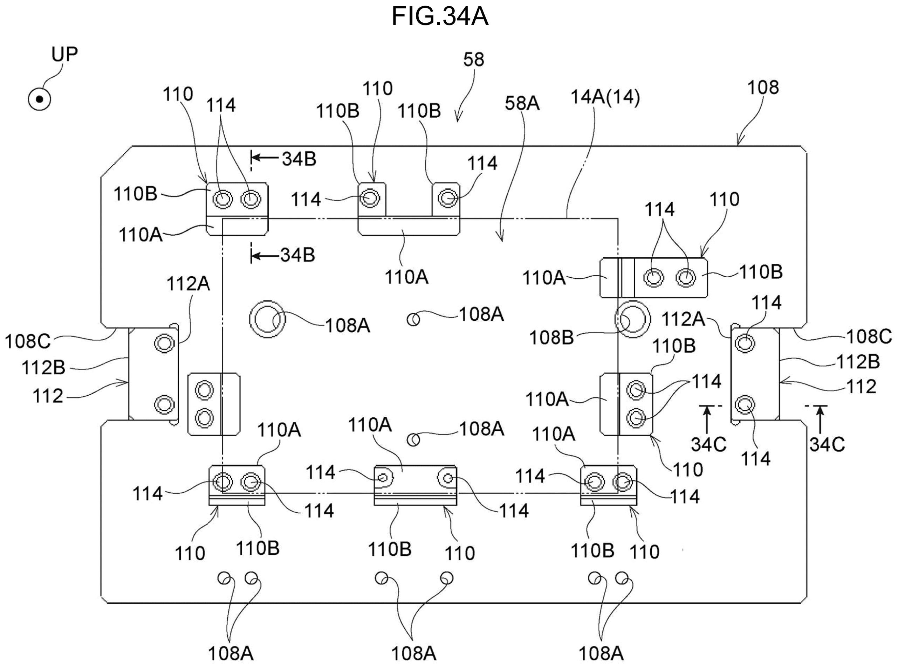

Next, description follows regarding a detailed configuration of the common conveyance jig 58, with reference to Fig. 34A to Fig. 34C.

Fig. 34A illustrates a plan view of the common conveyance jig 58 employed in the circuit board manufacturing device 10 and the circuit board manufacturing method described above, as viewed from above. As illustrated in these diagrams, the common conveyance jig 58 is configured including a base part 108, plural movement-restricting units 110 fixed to the base part 108, and plural gripped units 112 fixed to the base part 108.

The base part 108 is formed in a rectangular plate shape extending in a horizontal direction with a thickness direction aligned with the up-down direction. The base part 108 is formed with plural screw holes 108A into which fastening members 114 are screwed to fix the movement-restricting units 110 and the gripped units 112, described in detail later, to the base part 108. Note that Fig. 34A illustrates only some of the screw holes 108A, and other of the screw holes 108A have been omitted from illustration. Moreover, a pair of positioning portions 108B are formed in the base part 108. The pair of positioning portions 108B are arranged spaced apart from each other in the long side direction of the base part 108. Note that although the positioning portions 108B of the present exemplary embodiment are configured with a hole profile that passes through the base part 108 in the thickness direction thereof, they may be configured with an indented profile open to the lower side of the base part 108. Moreover, rectangular shaped cutout sections 108C notched in rectangular shapes are formed at short side direction central portions of the two long side direction end portions of the base part 108.

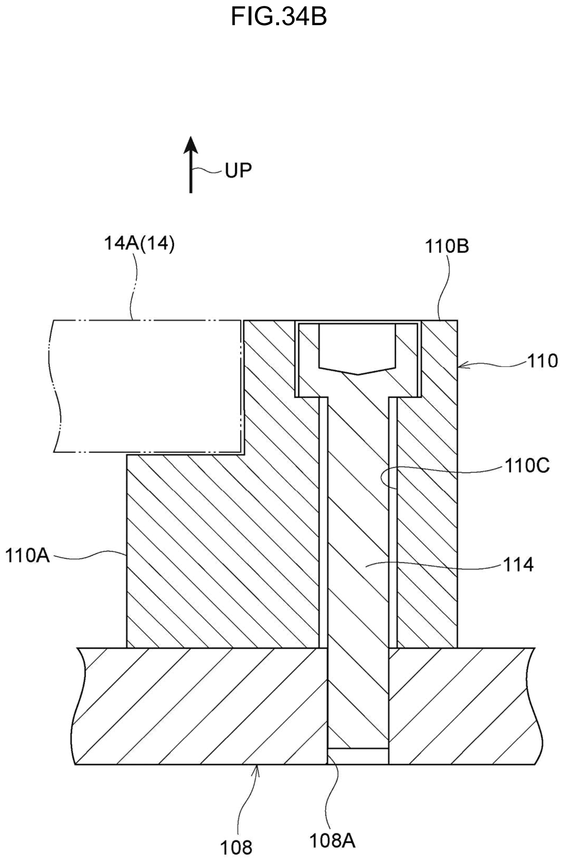

The plural movement-restricting units 110 are each formed in a block shape. In the present exemplary embodiment there are eight of the movement-restricting units 110 provided. Fig. 34B illustrates a cross-section of one of the movement-restricting units 110 sectioned along line 34B-34B of Fig. 34A. This movement-restricting unit 110 includes a rectangular block shaped first block portion 110A disposed along the upper face of the base part 108 in a state fixed to the base part 108. The movement-restricting unit 110 includes a rectangular block shaped second block portion 110B projecting upward from the first block section 110A. Two fastening member insertion holes 110C are formed in this movement-restricting unit 110 so as to pass through the first block portion 110A and the second block portion 110B in the up-down direction. The movement-restricting unit 110 is configured so as to be fixed to the base part 108 by screwing two fastening members 114, which have been inserted through two respective fastening member insertion holes 110C, into the screw holes 108A formed in the base part 108. Note that configuration is such that the upper end portions of the fastening members 114 do not project upward with respect to the upper face of the second block portion 110B in a state in which the movement-restricting units 110 have been fixed to the base part 108.

Moreover, the other seven of the movement-restricting units 110 also are configured similarly to the movement-restricting unit 110 described above, except for in the shape thereof and the locations where the fastening member insertion holes 110C are formed. Portions of the other seven movement-restricting units 110 corresponding to the movement-restricting unit 110 described above are accordingly appended with the same reference numerals as the corresponding portions of the movement-restricting unit 110 described above, and explanation thereof will be omitted. The eight movement-restricting units 110 are respectively fixed to the base part 108 in a state arranged at predetermined positions on the base part 108. A range surrounded by the eight movement-restricting units 110 on the base part 108 configures the board setting section 58A.

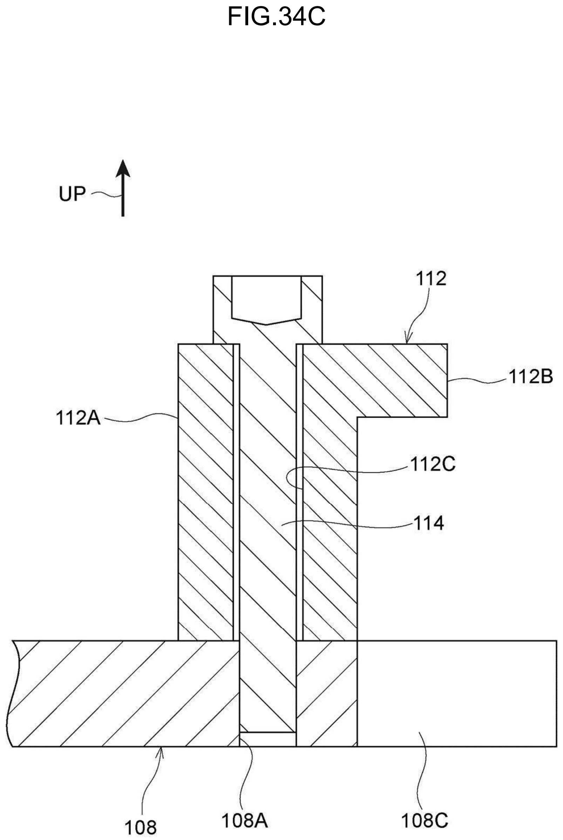

As illustrated in Fig. 34A, the plural gripped units 112 are each formed in a block shape. In the present exemplary embodiment there are two gripped units 112 provided. Fig. 34C illustrates a cross-section of one of the gripped units 112 sectioned along line 34C-34C of Fig. 34A. The gripped unit 112 includes a rectangular block shaped first block portion 112A arranged along the upper face of the base part 108 in a state fixed to the base part 108. The gripped unit 112 also includes a rectangular block shaped second block portion 112B that projects from an upper end of the first block portion 112A in a direction toward a horizontal direction one side. The gripped unit 112 is formed with two fastening member insertion holes 112C that pass through the first block portion 112A in the up-down direction. The gripped unit 112 is configured so as to be fixed to the base part 108 by screwing two fastening members 114, which have been inserted through the respective two fastening member insertion holes 112C, into the screw holes 108A formed in the base part 108. Note that configuration is such that the upper end portions of the fastening members 114 project upward with respect to the upper face of the first block portion 112A in a state in which the gripped unit 112 has been fixed to the base part 108.

Moreover, the shape and dimensions of the other gripped units 112 are configured similarly to the shape and dimensions of the one gripped unit 112. The portions of the other gripped unit 112 corresponding to the one gripped unit 112 are accordingly appended with the same reference numerals as the corresponding portions of the one gripped unit 112 described above, and explanation thereof will be omitted. The one gripped unit 112 and the other gripped unit 112 are fixed to positions on the base part 108 avoiding the board setting section 58A where the board 14 is supported from below and avoiding portions where the plural movement-restricting units 110 are fixed. As described later, the one gripped unit 112 is fixed at a position adjacent to one of the rectangular shaped cutout sections 108C on the base part 108. The other of the gripped units 112 is fixed at a position adjacent to the other of the rectangular shaped cutout sections 108C on the base part 108. Configuration is such that the second block portions 112B project out with respect to the first block portion 112A toward the opposite side to the board setting section 58A in a state in which the one gripped unit 112 and the other gripped unit 112 have been fixed at the above positions on the base part 108.

As illustrated in Fig. 34A and Fig. 34B, in the common conveyance jig 58 described above, the board 14 can be set on the board setting section 58A. In a state in which the board 14 has been set on the board setting section 58A, each portion of the plate shaped section 14A of the board 14 contacts the upper face of the respective first block portions 110A of the plural movement-restricting units 110. The board 14 is thereby supported from below by the base part 108, with the first block portions 110A of the plural movement-restricting units 110 interposed therebetween. Moreover, in a state in which the board 14 has been set on the board setting section 58A, each portion of the plate shaped section 14A of the board 14 is disposed in proximity to and opposing the respective second block portion 110B of the plural movement-restricting units 110 in a horizontal direction. Displacement of the board 14 in a horizontal direction with respect to the base part 108 is accordingly restricted by the second block portions 110B of the plural movement-restricting units 110. This thereby enables a single board 14 to be set on the board setting section 58A in the common conveyance jig 58 as described above.

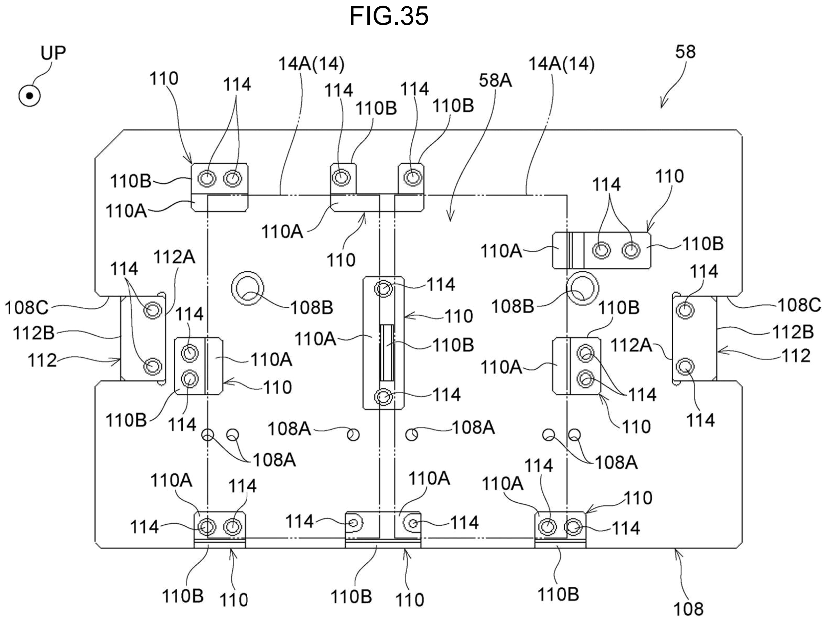

Moreover, in the common conveyance jig 58 as described above, the plural movement-restricting units 110 are configured so as to be detachably fixed to the base part 108 through the fastening members 114. This thereby enables boards 14 having different shapes and dimensions to each other to be supported by the base part 108 by varying the engagement locations of the plural movement-restricting units 110 with the base part 108. For example, as illustrated in Fig. 35, two boards 14 having dimensions smaller than those of the board 14 described above (see Fig. 34A) can be set on the board setting section 58A by varying the positional relationships on the base part 108 between the eight movement-restricting units 110 described above, and by adding one movement-restricting unit 110. Note that, as illustrated in Fig. 35, four boards 14 having dimensions smaller than those of the board 14 illustrated in Fig. 35 can be set on the board setting section 58A. Thus, the common conveyance jig 58 described above is able to accommodate plural specifications of circuit board 14.

Moreover, as illustrated in Fig. 34A to Fig. 34C, in the common conveyance jig 58 described above two gripped units 112 are fixed to the base part 108. This thereby enables the common conveyance jig 58 to be conveyed in a state in which the two gripped units 112 have been gripped by a non-illustrated gripping member.

Moreover, as illustrated in Fig. 34A, in the common conveyance jig 58 described above, the pair of positioning portions 108B are formed to the base part 108. This thereby enables the position of the base part 108 to be fixed by engaging a non-illustrated positioning member with the pair of positioning portions 108B formed to the base part 108. This thereby enables tasks to be performed on the base part 108 in a stabilized state.

Note that although an example has been described above in which the common conveyance jig 58 described above has a pair of positioning portions 108B formed to the base part 108, the present disclosure is not limited thereto. Whether or not a positioning portion 108B is formed in the base part 108 may be appropriately set in consideration of such factors as to whether or not there is a need to fix the position of the base part 108 in the processes for manufacturing the circuit board 14.

Moreover, although an example has been described above in which the common conveyance jig 58 described above includes the two gripped units 112 fixed to the base part 108, the present disclosure is not limited thereto. Whether or not two gripped units 112 are provided may be appropriately set in consideration of the configuration and the like of the conveyance path of the common conveyance jig 58.

Moreover, although an example has been described above in which the common conveyance jig 58 described above includes the plural movement-restricting units 110 formed in rectangular block shapes fixed to the base part 108, the present disclosure is not limited thereto. For example, a configuration may be adopted in which plural movement-restricting units 110 formed in pin shapes (for example, circular pillar shapes) have been detachably engaged with the base part 108.

Although an exemplary embodiment of the present disclosure has been described above, the present disclosure is not limited by the above, and obviously various other modifications may be implemented within a scope not departing from the spirit thereof.

The entire content of the disclosure of Japanese Patent Application No. 2023-001921 filed on January 10, 2023 is incorporated by reference in the present specification.

## Claims

1. A conveyance jig, employed to manufacture a circuit board including a board that is formed from a metal material, an insulation layer that is formed in a sheet shape from an insulating material and that is fixed on the board, and a circuit part that is formed from an electroconductive material and that is fixed on the insulation layer, the conveyance jig comprising:
a base part that supports the board from below; and
a plurality of movement-restricting units that detachably engage with the base part and restrict displacement, in a horizontal direction, of the board supported from below by the base part.

2. The conveyance jig of claim 1, further comprising a gripped unit that is fixed to a different portion of the base part from a portion at which the board is supported from below and from portions with which the plurality of movement-restricting units engage, and that is gripped by a gripping member.

3. The conveyance jig of claim 1, wherein a positioning portion, at which a positioning member engages, is formed at the base part.

4. A circuit board manufacturing device, comprising:
an insulation layer fixing unit that fixes the insulation layer on the board;
a circuit part fixing unit that fixes the circuit part on the insulation layer;
the conveyance jig of any one of claim 1 to claim 3; and
a conveyance unit that respectively conveys the conveyance jig to the insulation layer fixing unit and the circuit part fixing unit.

5. A circuit board manufacturing method employing the circuit board manufacturing device of claim 4, the circuit board manufacturing method comprising:
a first conveyance process of employing the conveyance jig and the conveyance unit to convey the board, in a state in which the insulation layer has been set, to the insulation layer fixing unit;
a first fixing process of fixing the insulation layer to the board by pressing the insulation layer toward a side of the board;
a second conveyance process of employing the conveyance jig and the conveyance unit to convey the board, in a state in which the circuit part is set on the insulation layer, to the circuit part fixing unit; and
a second fixing process of fixing the circuit part to the insulation layer by pressing the circuit part toward the side of the board.
